Europäisches Patentamt

European Patent Office

Office européen des brevets

(11) Publication number: **0 507 401 A2**

# EUROPEAN PATENT APPLICATION

(21) Application number: **92200901.4**

(22) Date of filing: **30.03.92**

(51) Int. Cl.5: **H03J 7/02**

(30) Priority: **05.04.91 GB 9107147**

(43) Date of publication of application:
**07.10.92 Bulletin 92/41**

(84) Designated Contracting States:
**AT DE FR GB**

(71) Applicant: **PHILIPS ELECTRONICS UK LIMITED**
**Philips House 1-19 Torrington Place**
**London WC1E 7HD(GB)**

(84) **GB**

(71) Applicant: **N.V. Philips' Gloeilampenfabrieken**
**Groenewoudseweg 1**
**NL-5621 BA Eindhoven(NL)**

(84) **DE FR AT**

(72) Inventor: **Bucknell, Paul**
**c/o Philips Research Laboratories**
**Redhilll, Surrey RH1 5HA(GB)**

(74) Representative: **Moody, Colin James et al**
**PHILIPS ELECTRONICS Patents and Trade**
**Marks Department Philips House 1-19**
**Torrington Place**
**London WC1E 7HD(GB)**

(54) **Frequency tracking arrangement, corresponding method of frequency tracking and a radio receiver embodying such an arrangement.**

(57) A frequency tracking arrangement comprises an input (30) to a frequency translation means (32) whose output is coupled to a filter and demodulator (34) which has both frequency (36), and amplitude (38) outputs. The frequency output is fed via a low pass filter (42) to a variable gain stage (44). The output of the gain stage (44) is fed to a feedback input of the frequency translation means (32). The amplitude output (38) of the filter and demodulator is fed to a control input of the variable gain stage (44). The amplitude output of the filter and demodulator is used to vary the amplitude of the feedback signal in the frequency tracking loop. When the arrangement is used in an FM radio receiver for audio, as the input signal weakens the frequency translation means (32) stops attempting to track the incoming signal. The subjective effect is that as the output signal amplitude diminishes relative to the noise, the receiver is less likely to search adjacent frequency bands and lock on to unwanted signals.

FIG.3

EP 0 507 401 A2

The present invention relates to a frequency tracking arrangement having particular, but not exclusive, application for use as a dynamically selective F.M. demodulator for frequency modulated (F.M.) signals. The invention also relates to a corresponding method of frequency tracking and to a radio receiver embodying such a method.

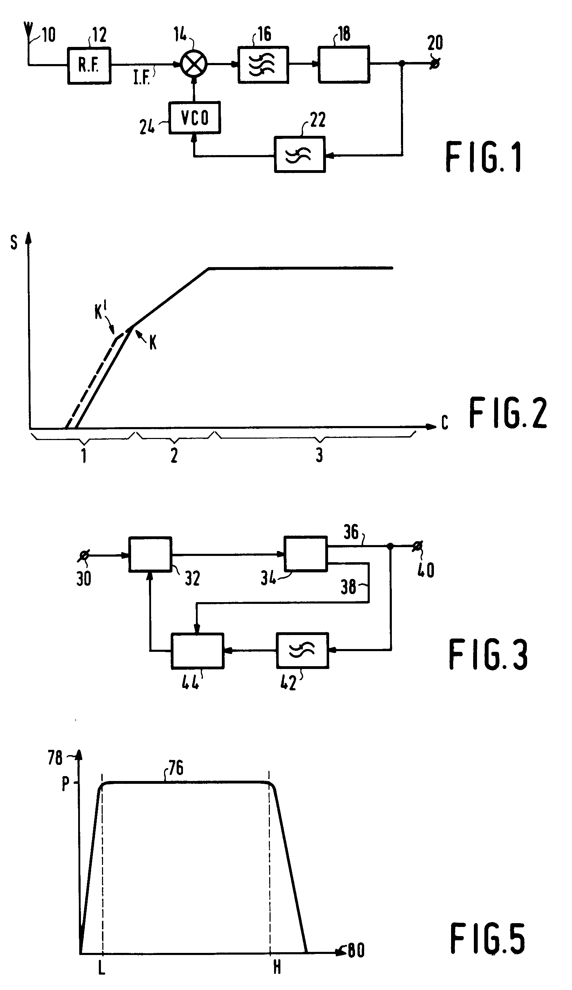

A demodulator for frequency modulated signals which employs feedback has been described by L. H. Enloe in "Decreasing the Threshold in FM by Frequency Feedback", Proceedings of the IRE January 1962 pages 18 to 30. Such a system is shown in block schematic form in Figure 1 of the accompanying drawings. Signals received at an antenna 10 are fed to a radio frequency (R.F.) front end 12 which amplifies and down converts the signals to a convenient intermediate frequency (I.F.). These intermediate frequency signals are fed to a first input to a mixer 14 which also has a second input for a local oscillator signal and an output. The output of the mixer is fed to an input to a bandpass I.F. filter 16 whose output is fed to an F.M. demodulator or frequency discriminator 18. The output of the frequency discriminator is fed to an output terminal 20 and also to an input to a low pass baseband filter 22. An output of the filter 22 is fed to a control terminal of a voltage controlled oscillator (V.C.O.) 24 having an output which is fed to the second input of the mixer 14.

The demodulator shown in Figure 1 can be arranged to operate in at least two different modes: automatic frequency control (A.F.C.) and frequency modulation with feedback (F.M.F.B.).

In the A.F.C. mode the I.F. filter 16 is arranged to have a relatively wide passband and the baseband filter 22 has a relatively narrow passband. The narrow passband of the filter 22 ensures that large, short term, frequency variations are not fed back to the V.C.O. 24. This means that when operating in A.F.C. mode the arrangement acts to track the average (or centre) frequency of the input signal with minimum interference from the modulation components of that signal.

In the F.M.F.B. mode of operation the I.F. filter 16 is arranged to have a comparatively narrow bandwidth and the baseband filter 22 is arranged to have a comparatively wide bandwidth. The baseband filter thus allows the V.C.O. to track the modulation components of the incoming signal more closely. This provides a reduced deviation signal within the loop and in conjunction with the I.F. filter having a narrower bandwidth provides improved noise immunity for the incoming signal.

An alternative architecture to that shown in Figure 1 is that of a zero intermediate frequency (Z.I.F.) receiver in which the output of the R.F. stage 12 comprises a pair of baseband signals in phase quadrature. The remaining receiver components need to be capable of handling quadrature signals and the filter 16 will be a low pass type.

Figure 2 of the accompanying drawings shows a pair of graphs of signal to noise ratio (S) against carrier to noise ratio (C) in which the solid line is for the demodulator of Figure 1 operating in the F.M.F.B. mode and the broken line will be referred to later. There are three distinct operating regions shown on the graph, numbered 1, 2 and 3. The first, or the threshold region 1, applies at very low carrier to noise ratios when the noise peaks on the incoming signal exceed the amplitude of the carrier for significant portions of time. In this region the output signal to noise ratio is very low but increases rapidly with increases in carrier to noise ratio. The second, or operating, region 2 is that in which the demodulator provides a signal to noise ratio at its output which is an improvement over that of the equivalent amplitude modulation demodulator. The third, or distortion, region 3 is reached when the circuits of the demodulator output cannot give any further increase in signal to noise ratio without saturating.

The critical area of operation of the demodulator is the "knee" K between the threshold region 1 and the operating region 2. The further to the left of the graph the knee K occurs, in other words at the lowest possible carrier to noise ratio, the better the selectivity performance of the demodulator. Improved selectivity has two main benefits, firstly the receiver is less likely to lose lock on a weak station due to the presence of a strong station nearby and secondly clicks due to noise on the received signal are less likely to be heard at the audio output. Numerous methods to reduce this latter problem have already been used but they all try to remove the clicks after they have been introduced by the demodulator. Improving the threshold of a receiver reduces the need for such post demodulation signal processing.

It is an object of the present invention to improve selectivity in a frequency tracking arrangement employing feedback.

According to a first aspect of the present invention there is provided a frequency tracking arrangement comprising a frequency translation means for converting an incoming signal to a frequency converted signal in response to a feedback signal, a demodulating means for demodulating the frequency converted signal to provide a frequency output signal and an amplitude output signal, and a feedback path comprising a filtering means and a variable gain means for filtering and varying the amplitude of the frequency output signal to provide the feedback signal to the frequency translation means, the gain of the variable gain means being responsive to the amplitude output of the demodulating means.

This arrangement operates by altering the amplitude of the feedback signal to the frequency translation means in accordance with the strength of the incoming signal. Where the arrangement is used in an F.M. receiver it can be arranged to provide a smaller feedback signal at lower incoming signal levels in order to allow greater stability. This is perceived by the user as the receiver remaining on a particular station's frequency even if the signal fades significantly and there is a stronger signal present on a nearby frequency. As is already known, a means may be provided somewhere within the receiver to mute the output if the received signal amplitude falls below a certain level.

The performance of the arrangement is governed by the transfer function of the variable gain stage, in other words the relationship between the amplitude of the signal used to control it and the amount of gain which it provides. One such relationship provides a gain which increases with increasing amplitude of the signal at the control input of the variable gain stage up to a first threshold. There is then a constant gain with increasing control signal amplitude until a second threshold, and finally a reduction to zero gain as the control signal amplitude increases beyond the second threshold. Another possible relationship provides a gain which increases with increasing signal amplitude until a threshold and maintains a constant gain at signal amplitudes above the threshold.

The filter in the feedback path may comprise a low pass device or a lead/lag device having break points at, for example 1kHz and 20 kHz.

The frequency tracking arrangement may be incorporated in a zero intermediate frequency (Z.I.F.) receiver in which case the frequency translation means will have an input and an output in phase quadrature. The demodulating means may incorporate a demodulator based upon an arctangent function or a CORDIC phase detector and where this demodulator or detector provides a phase output rather than a frequency output, this output may be fed to a differentiator which will provide a frequency output.

The arrangement may be realised as an entirely digital circuit and in such an instance, digitising means such as an analogue to digital converter will need to precede the arrangement.

The frequency translation means can be realised as a digital memory such as a read only memory (ROM) which may provide either a single output or quadrature related outputs.

A filter may be provided in series with the output of the frequency translation means and the bandwidth of this filter may be altered in accordance with the amplitude output of the demodulating means by a further means coupled to that amplitude output. One such further means provides control of the filter such that the filter has a comparatively wide bandwidth when the amplitude output is at a level above a certain threshold and a comparatively narrow bandwidth when the amplitude output is at a level below that threshold.

In order to prevent noise spikes and the like adversely affecting the feedback performance of the frequency tracking arrangement it may be desirable to insert a low pass filter between the amplitude output of the frequency demodulator and the variable gain stage. This filter may comprise an averaging filter.

According to a second aspect of the present invention there is provided a method of tracking frequency variations in an incoming signal, which method comprises frequency translating the incoming signal in accordance with a feedback signal to provide a frequency translated signal, demodulating the frequency translated signal to provide a frequency output signal and an amplitude output signal, and scaling the amplitude of the frequency output signal by a function of the amplitude output signal to provide the feedback signal for the frequency translation.

When using this method, the frequency translation may be performed by an exponential multiplication with an alternating signal which is generated in accordance with the control signal.

The amplitude of the alternating signal generated in accordance with the control signal may increase with an increasing amplitude output signal from the filtering and demodulating means, up to a certain threshold level above which the amplitude of the alternating signal is zero.

According to a third aspect of the present invention there is provided a radio receiver comprising a radio frequency (R.F.) stage for receiving and down converting a frequency modulated signal to an intermediate frequency (I.F.) signal, a frequency translation means for providing a frequency translated signal in response to the I.F. signal and a feedback signal, a demodulating means for providing at least a frequency output signal and an amplitude output signal in response to the frequency translated signal and a signal feedback path comprising filtering means and variable gain means for filtering and varying the amplitude of the frequency output signal to provide the feedback signal, the variable gain means being arranged to vary the amplitude of the feedback signal in response to the amplitude output signal.

In addition to using the amplitude output signal of the demodulating means to control the variable gain stage and a filtering means, a post demodulation filter may be included at the output of the receiver and the amplitude output signal may also effect control of this filter in order to vary its bandwidth.

According to a fourth aspect of the present invention there is provided a radio receiver comprising a radio frequency (R.F.) stage for receiving and down converting a frequency modulated signal to an intermediate frequency (I.F.) signal in response to a feedback signal, a frequency translation means for translating the I.F. signal to a frequency translated signal, a demodulating means for providing at least a frequency output signal and an amplitude output signal in response to the frequency translated signal, a signal feedback path comprising filtering means and variable gain means for filtering and varying the amplitude of the frequency output signal to provide the feedback signal, the variable gain means being arranged to vary the amplitude of the feedback signal in response to the amplitude output signal.

The receiver may operate at baseband quadrature. In common with the arrangement in accordance with the first aspect of the present invention, an amplitude limiting means may be included at the control input to the variable gain stage. This limiting means will operate in an analogous manner to the one previously described.

The present invention will now being described, by way of example, with reference to Figures 2 to 6 of the accompanying drawings, wherein:

Figure 2 shows a graph of signal to noise ratio against carrier to noise ratio for a conventional F.M.F.B. demodulator and for a demodulator made in accordance with the present invention,

Figure 3 shows a block schematic diagram of a frequency tracking arrangement in accordance with the present invention,

Figure 4 shows a F.M. radio receiver in accordance with the present invention,

Figure 5 shows two approximate transfer functions for an amplitude limiting means depicted in Figure 4, and

Figure 6 shows a further embodiment of a F.M. radio receiver in accordance with the present invention.

The arrangement shown in Figure 3 includes a terminal 30 for receiving an incoming signal. This incoming signal is fed to a first input to a frequency translator 32 also having a second input for receiving a feedback signal and an output. The output of the frequency translator 32 provides an input signal to a demodulator 34 which provides a frequency output signal 36 and an amplitude output signal 38. The output 36 is a demodulated version of the input signal and is fed to an output terminal 40 and to an input of a low pass or lead/lag filter 42. The output of the filter 42 is fed to an input to a variable gain stage 44 and the output of the variable gain stage is fed to the second input of the frequency translator 32. The output 38 of the demodulator 34 is a measure of the amplitude of the input signal and is fed to a control terminal of the variable gain stage 44. This arrangement differs from that shown in Figure 1 by the inclusion of the variable gain stage 44 in the feedback path. By modifying the degree of feedback to the frequency translator 32 an improvement in the stability of the system at low input signal levels may be obtained. It may be desired, for improved noise performance of the arrangement, to include a filter at the output of the frequency translation means.

The amplitude output signal 38 of the demodulator is proportional to the amplitude of the signal at its input which in turn is proportional to the strength of the incoming signal. When the incoming signal is weak the action of the variable gain stage is to reduce the amplitude of the feedback signal fed to the frequency translator 32. This has the effect of reducing the rate of change of frequency which the frequency translator may effect and thus as the incoming signal fades, the frequency tracking arrangement does not search adjacent frequency bands and commence tracking spurious signals to the same extent as an arrangement without variable amplitude feedback would. When the arrangement is used in a radio receiver the subjective effect is that the receiver is less likely to lose lock on a weak station in the presence of a strong station on a nearby frequency. In a typical frequency modulated radio application the bandwidth of the filter 42 will be of the order of 10 to 15 kHz.

The effect of an arrangement such as that shown in Figure 3 may be illustrated on a signal to noise (S) versus carrier to noise (C) graph such as the one shown in Figure 2. The broken line shown in Figure 2 illustrates the performance of an F.M.F.B. demodulator using amplitude feedback in accordance with the present invention. As can be seen, the "knee" of the curve has been moved to the left to a new position K' which signifies that a greater signal to noise ratio is obtainable at a given carrier to noise ratio than for a standard F.M.F.B. demodulator. The saturation level is, as in the embodiment shown in Figure 1, governed by the headroom of the output stage of the arrangement or by quantisation noise in a digital realisation.

The arrangement shown in Figure 3 is equally applicable to the tracking of an incoming signal at baseband which is represented by a pair of signals in phase quadrature. In this the frequency translation means must be capable of dealing with phase quadrature signals and may comprise an exponential multiplier coupled to an oscillator having outputs in phase quadrature. The input signal fed to the demodulator 34 is the phase quadrature output of the exponential multiplier. The demodulator itself may comprise a COordinate Rotation by DIgital Computer (CORDIC) arrangement which conveniently gives both phase and amplitude outputs. The frequency signal may be derived by time differentiation of the phase signal. Since the signals to be tracked are baseband signals any filter which precedes the demodulator will be a low pass filter.

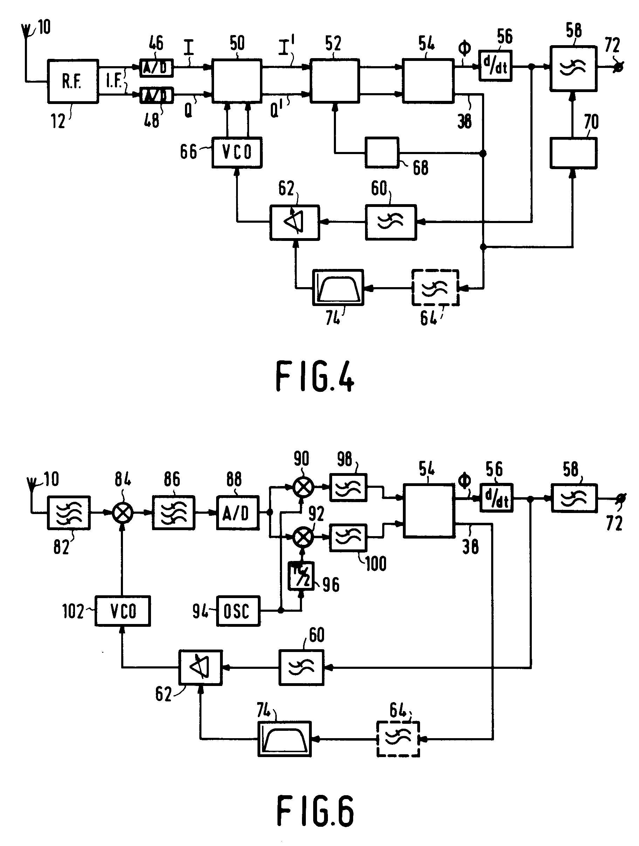

Figure 4 illustrates a radio receiver in accordance with the present invention. The signals received by an antenna 10 are fed to an R.F. stage 12 which amplifies and down converts the incoming signal to a convenient I.F. signal in phase quadrature. The phase quadrature outputs of the R.F. stage 12 are digitised by respective analogue to digital (A/D) converters 46,48 to provide an in-phase signal I and a quadrature signal Q. A single A/D converter may be multiplexed between the phase quadrature outputs to provide both I and Q signals. The digitised signals are fed to a first pair of inputs of an exponential multiplier 50 which also has a second pair of inputs for receiving a quadrature related local oscillator signal from a VCO 66 and a pair of outputs in phase quadrature. In a digital arrangement the VCO 66 may comprise a numerically controlled oscillator (NCO). The exponential multiplier 50 provides two frequency translated outputs, I',Q', to a channel filter 52. The channel filter 52 may advantageously comprise an infinite impulse response (IIR) device. The output of the filter 52 is in phase quadrature and is fed to an arctangent demodulator or frequency discriminator 54. The demodulator has a phase output ∅ which is fed to a differentiator 56 which provides a frequency signal at its output. This frequency signal is connected to the input of a post demodulation filter 58 and to the input of a feedback filter 60 which may comprise a low pass device or a lead/lag device. A lead/lag filter may conveniently have break points at 1 kHz and 20 kHz. The output of the post demodulation filter 58 is fed to a terminal 72 which comprises the output of the receiver. The output of the feedback filter 60 is fed to an input to a variable gain stage 62. The demodulator 54 also provides an amplitude output signal 38 which is fed to an optional low pass filter 64 and to inputs to filter characteristic varying means 68,70. The output of the filter 64 is fed to an amplitude limiting means 74 whose output is fed to a control input of the gain stage 62. An output of the gain stage 62 is fed to a voltage controlled oscillator (VCO) 66. The VCO 66 provides a pair of outputs in phase quadrature which are coupled to the second pair of inputs to the exponential multiplier 50. An output of the filter characteristic varying means 68 is fed to a control input of the channel filter 52. An output of the means 70 is fed to a control input of the filter 58.

In operation of this receiver, the exponential multiplier 50 operates to frequency translate the digitised version of the IF signals provided by the RF stage 12 to zero IF signals in phase quadrature I',Q', which zero IF signals are provided to channel filter 52. The output of this filter is demodulated in the same way as those signals in the arrangement shown in Figure 3 to provide both frequency and amplitude outputs. As mentioned above, the demodulator 54 provides an amplitude output and a phase output which is differentiated by the differentiator 56 to provide a corresponding frequency output signal. The demodulator 54 may comprise a COordinate Rotation by DIgital Computer (CORDIC) phase detector. The filter 60 and the variable gain stage 62 provide a filtered signal having a modified amplitude to the control input of the VCO 66. The amplitude output 38 is used to alter the gain of the feedback path by means of the control input to the gain stage 62. The rate at which the VCO 66 may track the incoming signal is thus governed by the amplitude of that signal. The low pass filter 64 may be included to reduce the effects upon the frequency tracking of spurious signals present at the amplitude output of the demodulator. The bandwidth of this filter is not at all critical and a value of approximately 10 Hz to 100 Hz should be suitable for an audio receiver application.

Figure 5 of the accompanying drawings shows two possible transfer functions for the amplitude limiting means 74 as shown in Figure 4. The horizontal axis 80 represents the amplitude of the input to that means and the vertical axis 78 represents the amplitude of its output. In a first possible function shown as a continuous line, while the amplitude of the input is below a first threshold L the amplitude of its output increases proportionally to the input amplitude up to a maximum value of P. While the input amplitude is above L but below a second threshold H, the output amplitude remains substantially at P. When the input amplitude rises above H the output decreases in proportion to the amount by which the input amplitude exceeds H. In a typical F.M. receiver the value of L may correspond to a signal strength of approximately 20μV (150Ω) at the input to the R.F. stage 12 (Figure 4), and that of H to approximately ten times that of L. The substantially flat portion of the transfer function in Figure 5 at amplitude P may correspond to a gain in the feedback loop of $1/\sqrt{2}$ which is a typical value of the fixed gain in a known receiver. A second possible function is the same as the first up to the threshold H. After that (as shown in a broken lines) the amplitude output remains substantially at P and does not reduce again. A number of different transfer functions may be applied by the limiting means 74 (Figure 4) and the examples given above are illustrative only.

Returning to Figure 4, in addition to using the amplitude output signal 38 of the demodulator 54 to alter the gain of the feedback path, the signal may also be used to vary either or both of the bandwidths of the channel filter 52 and the post demodulation filter 58. One technique for using the amplitude output signal 38 to modify the bandwidth of the channel filter 52 and the gain of the stage 62 is as follows:

1) For very low signal levels (below around $20\mu V$ ($150\Omega$) at the input to the R.F. stage): narrow channel filter and low loop gain,

2) For low level signals (between around $20\mu V$ ($150\Omega$) and $200\mu V$ ($150\Omega$) at the input to the R.F. stage): narrow channel filter and high loop gain, and

3) For high level signals (above around $200\mu V$ ($150\Omega$) at the input to the R.F. stage): wide channel filter and zero loop gain.

The signal levels suggested are, again, only approximate. For audio reception, a narrow channel filter will have a bandwidth of approximately 20 kHz and a wide channel filter will have a bandwidth of approximately 120 kHz.

An alternative strategy, similar to the one above maintains the high loop gain and narrow channel filter even at high signal levels. In other words, 3) above is ignored.

In addition, the perceived performance of the receiver to a user may be enhanced by reduction of the bandwidth of the post demodulation filter 58 by the means 70 in response to a reduction in the amplitude output 38.

The demodulator 54 may be realised as an arctangent demodulator or as a CO-ordinate Rotation by DIgital Computer (CORDIC) demodulator. Other demodulation techniques, such as a look-up table, may also be used.

The voltage controlled oscillator 66 may be implemented as a look-up table as is known in the art. Alternatively the exponential multiplier 50 and VCO 66 may be combined and realised as a single look-up table.

The point in the receiver to which the feedback correction signal is coupled may be altered if desired. The oscillator correction signal from the gain stage 62 may be coupled to the first I.F. oscillator in the R.F. stage 12 or to another oscillator or frequency down conversion stage within a receiver.

A radio receiver having a feedback signal applied to the first down-conversion stage is shown in Figure 6. In this receiver the frequency feedback is used to modulate the output of the first local oscillator rather than the last. Signals are received at an antenna 10 and are fed to a bandpass filter 82. For receiving broadcast FM signals in the United Kingdom this filter has a passband of 88MHz to 108MHz and it does not possess a particularly rapid roll-off outside of this band. The output of the filter 82 is fed to a first input of a mixer 84 also having a second input for connection to a local oscillator and an output. The output of the mixer 84 is fed to a second bandpass filter 86. The output of the mixer 84 is a modulated I.F. signal which for broadcast F.M. reception is typically centered on 10.7MHz and so for this application the filter 86 will have a passband centred on that frequency. The filter 86 is generally intended to provide a fairly high degree of selectivity so it will have much better out-of-band attenuation characteristics than the filter 82. The output of the filter 86 is fed to an analogue to digital (A/D) converter 88 which digitises the signal at an appropriate sampling rate. The digitised signal at the output of the A/D converter 88 is fed to the respective first inputs of a pair of mixers 90,92. The mixer 90 also has a second input which is fed from the output of a local oscillator (OSC) 94. The mixer 92 has a second input which is fed from the output of the OSC 94 via $\pi/2$ phase shifter 96. The mixers 90,92 may be replaced by an exponential multiplier and the OSC 94 and phase shifter 96 may be replaced by an oscillator having quadrature outputs. The outputs of the mixers 90,92 are fed to the inputs of respective low pass filters 98,100 whose outputs are coupled to a pair of inputs to a demodulator 54. The demodulator 54 provides an amplitude output signal on output 38 and a phase output signal $\emptyset$ which phase output is fed to an input to a differentiator (d/dt) 56. The output of the differentiator is fed to an input to a low pass filter 58 and to an input to a low pass filter 60. The output of the filter 58 is fed to a terminal 72 which comprises the output of the receiver. The output of the filter 60 is fed to an input to a variable gain stage 62. The amplitude output signal 38 is fed to an optional low pass filter 64 shown in broken lines on the figure. The output of the filter 64 is fed to an amplitude limiting means 74 whose output is fed to a control input of the gain stage 62. The output of the gain stage 62 is fed to a control input of a voltage controlled oscillator (VCO) 102. The output of the VCO 102 is fed to the second input to the mixer 84. Where the signal fed back via the gain stage 62 is a digital signal, the VCO 102 will comprise a Numerically Controlled Oscillator (NCO). While no means are shown in Figure 6 to alter the bandwidth of the filters 98,100 and 58 it will be understood that means similar to those means 68,70 (Figure 4) could be included and have a similar behaviour in response to variations in the strength of the amplitude output signal 38.

In operation, signals received at the antenna are coarsely filtered and mixed with a local oscillator signal to provide a down converted signal, typically at an I.F. of 10.7MHz. Unwanted image frequencies at the output of the mixer 84 are removed by the filter 86 and the filtered I.F. signal is digitised in A/D converter 88. Components 90 to 100 form a well known quadrature mixing and filtering arrangement whose output is a pair of filtered baseband quadrature signals. The phase detector 54, d/dt 56, filter 58, filters 60,64, limiter 74, and gain stage 62 all function as in the previously described embodiment. The VCO 102 differs from the VCO 66 (Figure 4) in that it provides only a single output and operates between approximately 78MHz and 98MHz rather than at around 10.7MHz. The VCO 102 is controlled to track variations in the frequency of the received signal and the rate at which the tracking may take place is dependent upon the amplitude of the received signal in an analogous way to that of the receiver shown in Figure 4. One advantage of this layout over the earlier one is that the addition of the amplitude dependent feedback will generally entail less alteration to a known receiver design. A possible disadvantage is that the increased delay around the feedback loop, especially in the filter 86, will reduce the effect of the amplitude dependent feedback and the performance of this receiver may be poorer than that of the one shown to Figure 4.

Where a receiver is to be used in a noisy environment such as a motor vehicle with spark ignition, the optional low pass filter 64 may advanteously be an averaging filter not an integrating one. The averaging filter includes a constant plus a variable multiplier, and thus prevents large short term spikes from affecting its output substantially.

From reading the present disclosure, other modifications will be apparent to persons skilled in the art. Such modifications may involve other features which are already known in the design, manufacture and use of arrangements for frequency tracking of signals, and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

**Claims**

1. A frequency tracking arrangement comprising a frequency translation means for converting an incoming signal to a frequency converted signal in response to a feedback signal, a demodulating means for demodulating the frequency converted signal to provide a frequency output signal and an amplitude output signal, and a feedback path comprising a filtering means and a variable gain means for filtering and varying the amplitude of the frequency output signal to provide the feedback signal to the frequency translation means, the gain of the variable gain means being responsive to the amplitude output of the demodulating means.

2. An arrangement as claimed in Claim 1, wherein the frequency translation means includes a digital memory.

3. An arrangement as claimed in Claim 1 or Claim 2, wherein the demodulator includes a CORDIC phase detector.

4. An arrangement as claimed in any one of the Claims 1 to 3, wherein the variable gain means includes an amplitude scaling means for providing a predetermined relationship between the amplitude output signal of the demodulating means and the gain of the variable gain means.

5. An arrangement as claimed in Claim 4, wherein the predetermined relationship is such as to provide a gain which increases with increasing amplitude at the amplitude output of the demodulating means while that amplitude output is below a threshold level and is substantially constant while that amplitude output is above the threshold level.

6. A method of tracking frequency variations in an incoming signal, which method comprises frequency translating the incoming signal in accordance with a feedback signal to provide a frequency translated signal, demodulating the frequency translated signal to provide a frequency output signal and an amplitude output signal, and scaling the amplitude of the frequency output signal by a function of the amplitude output signal to provide the feedback signal for the frequency translation.

7. A radio receiver comprising a radio frequency (R.F.) stage for receiving and down converting a frequency modulated signal to an intermediate frequency (I.F.) signal, a frequency translation means for providing a frequency translated signal in response to the I.F. signal and a feedback signal, a demodulating means for providing at least a frequency output signal and an amplitude output signal in response to the frequency translated signal and a signal feedback path comprising filtering means and variable gain means for filtering and varying the amplitude of the frequency output signal to provide the feedback signal, the variable gain means being arranged to vary the amplitude of the feedback signal in response to the amplitude output signal.

8. A radio receiver comprising a radio frequency (R.F.) stage for receiving and down converting a frequency modulated signal to an intermediate frequency (I.F.) signal in response to a feedback signal, a frequency translation means for translating the I.F. signal to a frequency translated signal, a demodulating means for providing at least a frequency output signal and an amplitude output signal in response to the frequency translated signal, a signal feedback path comprising filtering means and variable gain means for filtering and varying the amplitude of the frequency output signal to provide the feedback signal, the variable gain means being arranged to vary the amplitude of the feedback signal in response to the amplitude output signal.

9. A radio receiver as claimed in Claim 7 or Claim 8, wherein the variable gain means includes an amplitude scaling means for providing a predetermined relationship between the amplitude output signal from the demodulating means and the gain of the variable gain means.

10. A radio receiver as claimed in Claim 9, wherein the predetermined relationship is such as to provide a gain which increases with increasing amplitude of the amplitude output signal from the demodulating means while that amplitude output is below a threshold level and is substantially constant while that amplitude output signal is above the threshold level.

FIG.1

FIG.2

FIG.3

FIG.5

FIG.4

FIG.6